(19) **Europäisches Patentamt**
**European Patent Office**
**Office européen des brevets**

(11) **EP 2 658 002 B1**

(12) **EUROPEAN PATENT SPECIFICATION**

(45) Date of publication and mention
of the grant of the patent:
**18.11.2015 Bulletin 2015/47**

(51) Int Cl.:
**H01L 35/16** *(2006.01)*    **C01B 19/00** *(2006.01)*
**H01L 35/18** *(2006.01)*

(21) Application number: **13165640.7**

(22) Date of filing: **26.04.2013**

(54) **Thermoelectric material having reduced thermal conductivity**

Thermoelektrisches Material mit einer verminderten Wärmeleitfähigkeit

Matériau thermoélectrique ayant une conductivité thermique réduite

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.04.2012 KR 20120044666**

(43) Date of publication of application:
**30.10.2013 Bulletin 2013/44**

(73) Proprietor: **Samsung Electronics Co., Ltd
Gyeonggi-do 443-742 (KR)**

(72) Inventors:
• **Kim, Sang-il**
**449-712 Gyeonggi-do (KR)**
• **Lee, Kyu-hyoung**
**449-712 Gyeonggi-do (KR)**
• **Hwang, Sung-woo**
**449-712 Gyeonggi-do (KR)**
• **Ahn, Kyung-han**
**449-712 Gyeonggi-do (KR)**

(74) Representative: **Zijlstra, Robert Wiebo Johan
Elkington and Fife LLP
Prospect House
8 Pembroke Road
Sevenoaks, Kent TN13 1XR (GB)**

(56) References cited:
**WO-A1-2011/051771    US-A1- 2011 248 210**

• **XIE W J ET AL: "Nanostructure and thermoelectric properties of p-type Bi0.5Sb1.5Te3 compound prepared by melt spinning technique", THERMOELECTRICS, 2007. ICT 2007. 26TH INTERNATIONAL CONFERENCE ON, IEEE, PISCATAWAY, NJ, USA, 3 June 2007 (2007-06-03), pages 23-26, XP031288456, ISBN: 978-1-4244-2262-3**
• **SANG IL KIM ET AL: "Enhancement of Seebeck Coefficient in Bi0.5Sb1.5Te3 with High-Density Tellurium Nanoinclusions", APPLIED PHYSICS EXPRESS, JAPAN SOCIETY OF APPLIED PHYSICS; JP, JP, vol. 4, no. 9, 1 September 2011 (2011-09-01), pages 91801-1, XP001573692, ISSN: 1882-0778, DOI: 10.1143/APEX.4.091801 [retrieved on 2011-09-07]**
• **WENJIE XIE ET AL: "Identifying the Specific Nanostructures Responsible for the High Thermoelectric Performance of (Bi,Sb) 2 Te 3 Nanocomposites", NANO LETTERS, vol. 10, no. 9, 8 September 2010 (2010-09-08), pages 3283-3289, XP055138301, ISSN: 1530-6984, DOI: 10.1021/nl100804a**
• **TING ZHANG ET AL: "In Situ Precipitation of Te Nanoparticles in p-Type BiSbTe and the Effect on Thermoelectric Performance", ACS APPLIED MATERIALS & INTERFACES, vol. 5, no. 8, 24 April 2013 (2013-04-24), pages 3071-3074, XP055138314, ISSN: 1944-8244, DOI: 10.1021/am303145v**
• **SHUFEN FAN ET AL: "Influence of Nanoinclusions on Thermoelectric Properties of n-Type Bi2Te3 Nanocomposites", JOURNAL OF ELECTRONIC MATERIALS, vol. 40, no. 5, 1 May 2011 (2011-05-01), pages 1018-1023, XP055138315, ISSN: 0361-5235, DOI: 10.1007/s11664-010-1487-7**

EP 2 658 002 B1

- IVANOVA L D ET AL: "Thermoelectric and mechanical properties of the BiSbTesolid solution prepared by melt spinning", INORGANIC MATERIALS, NAUKA/INTERPERIODICA, MO, vol. 49, no. 2, 5 January 2013 (2013-01-05), pages 120-126, XP035159119, ISSN: 1608-3172, DOI: 10.1134/S0020168513020106
- BED POUDEL ET AL: "High-Thermoelectric Performance of Nanostructured Bismuth Antimony Telluride Bulk Alloys", SCIENCE, AMERICAN ASSOCIATION FOR THE ADVANCEMENT OF SCIENCE, US, vol. 320, no. 5876, 2 May 2008 (2008-05-02), pages 634-638, XP008147704, ISSN: 0036-8075, DOI: 10.1126/SCIENCE.1156446 [retrieved on 2008-03-20]

**Description**

FIELD OF THE INVENTION

The present disclosure relates to a high efficiency thermoelectric material. The thermoelectric material forms high-density interface dislocation to reduce thermal conductivity thereby providing improved thermoelectric performance.

BACKGROUND OF THE INVENTION

In general, thermoelectric effect, which directly converts temperature difference into electricity and vice-versa, is a key technology for renewable energy harvesting and solid-state refrigeration. It is a phenomenon occurring as a result of phonon transfer due to the movement of electrons and holes inside a material. It is divided into Peltier effect, which utilizes a temperature gradient established across both ends by the current applied from outside, in the field of cooling, and Seebeck effect, which utilizes electromotive force generated by a temperature gradient at both ends in power generation.

Thermoelectric energy conversion technology offers energy generation to use enormous waste heat from many industries as well as next-generation solid-state cooling to replace inefficient vapor-compression cycle technologies.

The thermoelectric cooling using a thermoelectric material is an environmentally-friendly cooling technology with zero vibration and low noise, achieved without using a refrigerant gas harmful to the environment. In addition, the improvement of cooling efficiency by using thermoelectric cooling via development of a material for high efficiency thermoelectric cooling may be expanded to applications related to general purpose cooling such as with refrigerators, air conditioners, and the like. Further, the use of a thermoelectric generation material as a heat sink in vehicle engines, industrial plants, etc., enables generation of power due to a temperature gradient occurring across both ends and is thus applicable as a renewable energy source.

As an example of the thermoelectric (TE) material, $(Bi,Sb)_2(Te,Se)_3$-based material is the only thermoelectric material usable at around room temperature, and it may be used in cooling and power generation using low-temperature waste heat. However, for $(Bi,Sb)_2(Te,Se)_3$-based materials, which are the most dominantly used TE materials near room temperature, the thermoelectric figure of merit, which represents the properties of a thermoelectric material, has remained at the level of 1.0 for the past 50 years. Since the efficiency of TE technology is crucially subjected to the energy conversion performance of materials, most of researches have been focused on the development of highly efficient materials, the improvement in the properties of $(Bi,Sb)_2(Te,Se)_3$-based materials as a thermoelectric material will considerably expand its field of application.

XIE W J ET AL: "Nanostructure and thermoelectric properties of p-type Bi0.5Sb1.5Te3 compound prepared by melt spinning technique", THERMOELECTRICS, 2007. ICT 2007. 26TH INTERNATIONAL CONFERENCE ON, IEEE, PISCATAWAY, NJ, USA, 3 June 2007 (2007-06-03), pages 23-26, XP031288456 discloses a nanostructure and thermoelectric properties of p-type $Bi_{0.5}Sb_{1.5}Te_3$ compound prepared by a melt spinning technique.

SUMMARY OF THE INVENTION

Provided is a thermoelectric material with improved thermoelectric performance achieved by considerably reducing its thermal conductivity.

In an aspect of the present invention, there is provided a thermoelectric material including a thermoelectric matrix comprising grains with a composition of Formula 1:

$$\text{Formula 1} \qquad (Bi_xSb_{1-x})_a(Te_ySe_{1-y})_b$$

wherein, $1.8 \leq a \leq 2.2$, $2.8 \leq b \leq 3.2$, $0 \leq x \leq 1$, and $0 \leq y \leq 1$, and
wherein at least one grain boundary in said thermoelectric matrix comprises a plurality of dislocations.

In an embodiment, the thermoelectric material may further include a metal additive having a lattice matching structure with the grains.

In another aspect of the present invention, there is provided a method for manufacturing thermoelectric material including:

heating a precursor material comprising a flux or additive and a composition of Formula 1 to obtain a melt

$$\text{Formula 1} \qquad (Bi_xSb_{1-x})_a(Te_ySe_{1-y})_b,$$

wherein $1.8 \leq a \leq 2.2$, $2.8 \leq b \leq 3.2$, $0 \leq x \leq 1$, and $0 \leq y \leq 1$;

solidifying the melt to form a solidified intermediate;
pressure-sintering the solidified intermediate to obtain the thermoelectric material,

wherein the thermoelectric material has a plurality of dislocations along a grain boundary of the composition of Formula 1.

BRIEF DESCRIPTION OF THE DRAWINGS

These and/or other aspects will become apparent and more readily appreciated from the following description of the embodiments, taken in conjunction with the accompanying drawings of which:

FIG. 1 is a diagram illustrating dislocation occurring at the interface of a lattice;
FIG. 2 shows a schematic diagram of a thermoelectric module employing a thermoelectric device according to an embodiment;
FIG. 3 shows a schematic diagram of thermoelectric module employing a thermoelectric device according to another embodiment;
FIG. 4 shows a schematic diagram of thermoelectric module employing a thermoelectric device according to still another embodiment;
FIG. 5 shows ribbons prepared in Example 1;
FIGS. 6 to 9 respectively show surface fine structures of ribbons prepared in Example 1;
FIGS. 10 to 11 respectively show cross-sectional fine structures of ribbons prepared in Example 1;
FIGS. 12 to 13 respectively show transmission electron microscopy (TEM) images illustrating semi-coherent interfaces of a thermoelectric material prepared in Example 1;
FIGS. 14 to 15 respectively show TEM images illustrating semi-coherent interfaces of a thermoelectric material prepared in Example 1;
FIGS. 16 to 22 respectively show TEM images illustrating semi-coherent interfaces of a thermoelectric material prepared in Example 1;
FIGS. 23 to 29 respectively show TEM images illustrating semi-coherent interfaces of a thermoelectric material prepared in Example 1;
FIG. 30 shows electrical conductivity of thermoelectric materials prepared in Example 1, Example 2, Comparative Example 1 and Comparative Example 2;
FIG. 31 shows the Seebeck coefficient of thermoelectric materials prepared in Example 1, Example 2, Comparative Example 1 and Comparative Example 2;
FIG. 32 shows the power factor of thermoelectric materials prepared in Example 1, Example 2, Comparative Example 1 and Comparative Example 2;
FIG. 33 shows thermal conductivity of thermoelectric materials prepared in Example 1, Example 2, Comparative Example 1 and Comparative Example 2;
FIG. 34 shows lattice thermal conductivity of thermoelectric materials prepared in Example 1, Example 2, Comparative Example 1 and Comparative Example 2;
FIG. 35 shows thermoelectric figure of merit of thermoelectric materials prepared in Example 1, Example 2, Comparative Example 1 and Comparative Example 2;
FIGS. 36A, 36B, 36C and 36D show TEM images of thermoelectric materials prepared in Example 1, wherein the images are respectively at different magnifications and a high defect density is observed among grains of the materials at high magnifications;
FIG. 37A shows a TEM image of a thermoelectric material prepared in Example 1;
FIG. 37B and 37C show a filtered image of spots on $Bi_{0.5}Sb_{1.5}Te_3$ (1 1 -6) face and (1 1 0) face in the lattice diffraction pattern of a TEM image having dislocations illustrating a regular structure of dislocations;
FIGS. 38A and 38B respectively show lattice diffraction patterns of FIGS. 37A and 37B in Example 1;
FIG. 39A shows a TEM image of thermoelectric materials prepared in Example 1, wherein a strain field is observed at the interface; and
FIGS. 39B and 39C respectively show lattice diffraction patterns of FIG. 39A in Example 1.

DETAILED DESCRIPTION OF THE EMBODIMENTS

Reference will now be made in detail to embodiments, examples of which are illustrated in the accompanying drawings, wherein like reference numerals refer to the like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items.

In an aspect, there is provided a thermoelectric material including a thermoelectric matrix which has grains of a $(Bi,Sb)_2(Te,Se)_3$-based composition, wherein at least one grain boundary comprises a dislocation. The dislocation is formed spontaneously during densification process wherein excess Te facilitates grain rearrangements, accommodating mismatches of near coincidence site lattices of the adjacent grains.

When grain rearrangements occur during sintering, grain boundary forms high density dislocation to form crystallographic relationship to lower grain boundary energy. The dislocation is formed due to the mismatch of near coincidence site lattices of the adjacent grains, i.e. high density dislocations reduces a thermal conductivity of the thermoelectric material.

The performance of a thermoelectric material can be calculated by Equation 1 below, generally referred to as a dimensionless figure of merit.

<Equation 1>

$$ZT = (S^2 \sigma T)/\kappa$$

wherein, S is Seebeck coefficient, $\sigma$ is thermal conductivity, T is absolute temperature, and $\kappa$ is thermal conductivity.

As shown in the Equation 1, in order to increase the ZT value of a thermoelectric material, Seebeck coefficient and thermal conductivity, i.e., its power factor ($S^2\sigma$), should be increased while decreasing its thermal conductivity. However, Seebeck coefficient and thermal conductivity exhibit a trade-off relationship in that when there is an increase in one value, the other value decreases according to the concentration of an electron or a hole as a carrier, thus greatly limiting the increase in the power factor.

With the rapid growth in nanostructure technology during the late 1990s, it has been made possible to manufacture super lattice thin films, nanowires, quantum dots, etc., and superior thermoelectric performance of these materials has been achieved by increasing Seebeck coefficient by quantum confinement effect or by decreasing thermal conductivity based on the concept of phonon glass electron crystal (PGEC).

The quantum confinement effect is a concept that increases Seebeck coefficient by increasing the density of state of carriers in the material, thereby enlarging effective mass of the carriers while preventing their thermal conductivity from being considerably changed (destroying the trade-off between thermal conductivity and Seebeck coefficient).

The PGEC concept relates to reducing only the thermal conductivity of carriers by blocking the movement of phonons which are involved in heat transfer without preventing the movement of carriers.

In an embodiment, the thermoelectric material is prepared based on the PGEC concept, where the movement of phonons is blocked by using the regular dislocations formed at semi-coherent interface without preventing the transport of carriers, thereby lowering thermal conductivity and achieving excellent thermoelectric performance. The size of the strain field of the high density dislocation is in the range of about 1nm to about 50nm, and it may become an effective lattice defect in thermal conductivity of $(Bi,Sb)_2(Te,Se)_3$-based thermoelectric matrix.

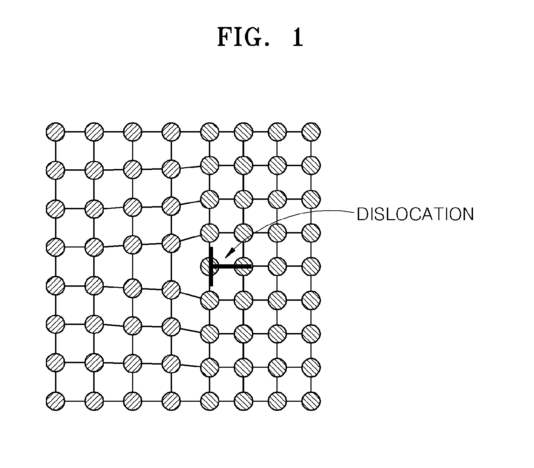

The dislocation, as shown in FIG. 1, is formed when two different lattices with similar lattice constant are in close contact to form an interface, and it accompanies strain and stress. This is formed due to the similarity in the distance between lattice surfaces among crystal faces of lattices, and the interfaces including the dislocation are called semi-coherent interfaces.

The generation of grain boundary dislocations can be explained by coincident site lattice (CSL) or structural-unit models. At certain orientation relationship is established between adjacent grains as to have lower grain boundary energy during the grain rearrangement by the transient liquid-Te self-flux sintering. For some discrete misorientations between grain crystals, a coincident site lattice, which is common to the two adjacent grains, may be defined. The deviation from the exact coincidence site (Near-CSL) lattice misorientation creates high-density dislocations at the boundary.. It can be simply thought of periodic misfit dislocations formed due to d-spacing (interplanar spacing) mismatch of adjacent grains at a certain orientation relationship. This can lower grain boundary energy and result in forming dislocations. The provided method with excess Te during the sintering process enables the grain rearrangement that can form crystallographic relationship to lower grain boundary energy. The spacing between dislocations can be calculated by the difference in the lattice constant between the two different materials or the difference in an interplanar distance of each crystal face of two different lattices.

Here, depending on the type of materials, a semi-coherent interface may be formed, when the maximum difference in the lattice constant between the two different lattices having matching lattice structures or the maximum difference in the interplanar distance between the crystal faces of two different lattices is from about 7% to about 15%. The semi-coherent interface may be formed between different materials but it may be formed among crystal faces where the mismatch in lattice constant among a plurality of crystal faces of grains in thermoelectric matrix is a few% or less.

Meanwhile, $(Bi,Sb)_2(Te,Se)_3$-based lattices have a complex atom configuration and thus they have a plurality of crystal faces, and of them, a semi-coherent interface may be formed among the crystal faces having a similarity in the interplanar distance between the crystal faces. When a difference of the interplanar distance between the crystal faces in the two different lattices exceeds a predetermined range, an incoherent interface is formed, and neither strain nor stress is accompanied therein.

In another aspect, a semi-coherent interface may be formed between the grain boundary in the thermoelectric matrix which includes the grains with the composition of Formula 1 below,

[Formula 1]

$$(Bi_xSb_{1-x})_a(Te_ySe_{1-y})_b$$

wherein, $1.8 \leq a \leq 2.2$, $2.8 \leq b \leq 3.2$, $0 \leq x \leq 1$, and $0 \leq y \leq 1$.

The lattice of grains with the composition of the Formula 1 has a rhombohedral structure where a is about 4.3Å, and c is about 30.45Å, and when a semi-coherent interface is formed on the grain boundary in the thermoelectric matrix, dislocations are regularly formed along the above boundary. For example, the above dislocations may be formed along the above semi-coherent interface at intervals of about 1nm to about 100nm, or about 2nm to about 20nm.

Examples of the thermoelectric matrix forming the semi-coherent interface include nano-structured grains having the composition of the Formula 1.

The semi-coherent interface may be formed between grains in the thermoelectric matrix, and the grain boundary may have lattice matching structure.

The thermoelectric material may further include a metal additive (inclusion) having a lattice matching structure with the thermoelectric matrix.

The metal additive may form a semi-coherent interface among them by constituting a complex by adding a material having a structure similar to that of the rhombohedral lattice structure, where a is about 4.3Å, and c is about 30.45Å, for example, a material with a lattice matching structure. In the semi-coherent interface where the grains and the metal additive are in contact, regular high density dislocations are formed due to the lattice matching and thus a thermal conductivity of the thermoelectric material may be reduced.

In the semi-coherent interface, as described above, the difference in the lattice constant between the grains in the thermoelectric matrix and the metal additive is 7% or less, for example, a difference of 2% to 4%.

The metal additive may be dispersed in the thermoelectric matrix in the form of inclusions, and may form a semi-coherent interface along with the nano-structured grains which constitute the thermoelectric matrix.

The metal additive which forms a semi-coherent interface along with the thermoelectric matrix may have a content of 0.1 volume % or more, for example, 0.1 volume % to 10 volume %, based on a total volume of the thermoelectric material.

The metal additive may have a planar, columnar, acicular or spherical structure. In the case of a planar structure, the metal additive may be present along the grain boundary of the thermoelectric material. In the case of a spherical structure, it may be present inside the grains of the thermoelectric material.

The thickness of the planar metal additive (sectional length) may be 1 nm to 100nm. The radius of the spherical metal additive may be 1 nm to 100nm.

The metal additive which forms a semi-coherent interface with the grains of the thermoelectric matrix may include a metal, for example, at least one selected from transition metals, Group I elements, Group II elements, Group XIII elements, Group XIV elements, Group XV elements, and Group XVI elements, except for non-metals.

For example, tellurium (elementary symbol: Te, atomic number: 52) among Group XVI elements has a hexagonal structure where lattice constant a is 4.458 and c is 5.927Å and has a lattice matching structure which has a difference in lattice constant in the range of about 3% or less between tellurium and the thermoelectric matrix with a composition of Formula 1, e.g. $(Bi,Sb)_2(Te,Se)_3$-based thermoelectric material. Therefore, a semi-coherent interface is formed between tellurium and the $(Bi,Sb)_2(Te,Se)_3$-based thermoelectric material thereby forming regular dislocations, and each dislocation can form a strain-field domain structure. The dislocation may be present at high density on the interface of the $(Bi,Sb)_2(Te,Se)_3$-based thermoelectric material. The dislocation density may be in a range of about $10^{10} \sim 10^{12}/cm^2$. For example, the dislocation density may be about $10^{11}/cm^2$.

The metal additive which can form a semi-coherent interface with the grains in the thermoelectric matrix may include, for example, a chalcogenide compound. The chalcogenide compound is a material, where at least one of S, Se, and Te is bound to a metal, and the metal may be one or more selected from Bi, Sb, Pb, Sr, Ag, rare earth elements, and transition metals.

The metal to be used as the metal additive or the chalcogenide compound may be used in combination.

When a semi-coherent interface is formed between the grains of the thermoelectric matrix as described above, the semi-coherent interface may occur alone in the thermoelectric material or may be present along with the semi-coherent interface formed in the interface between the grains and the metal additive when the thermoelectric material includes the metal additive.

As described above, regular high density dislocations are formed on the grain boundary or on the interface between the grains and the metal additive due to the lattice matching. The dislocations may be formed at high density at intervals of 2nm to 10 nm.

In an embodiment, the {0 1 10}, {0 1 11}, {1 1 0}, {0 0 15}, {1 1 -6} faces of a $(Bi,Sb)_2(Te,Se)_3$-based lattice respectively have a similar interplanar distance of about 2.35, 2.22, 2.13, 2.03, 1.96 Å, and thus when the crystal orientation is rearranged they become lattice matching, and misfit dislocations may be formed thereon.

The misfit dislocations formed on the grain boundary or on the interface between the grains and the metal additive and the complex dislocations generated as a result of their correlation form a strain field, thereby considerably reducing the lattice thermal conductivity via phonon scattering. Further, the misfit dislocations are formed at high density at intervals of about a few nm to about a few tens of nm, thus being effective in reducing thermal conductivity. As the thermal conductivity becomes drastically reduced, the thermoelectric material may have a thermal conductivity of 0.4 W/mK or less, 0.35 W/mK or less, or 0.35 W/mK to 0.1 W/mK, at room temperature, for example, about 300K.

Such reduced thermal conductivity indicates the improvement in the thermoelectric figure of merit (ZT). The metal additive-containing thermoelectric material may have a ZT of 1.3 or above, for example, 1.5 or higher, or 1.6 to 3.0, at room temperature, for example, 300K.

In an embodiment, thermoelectric materials with high ZT may be obtained, for example, having high thermoelectric performance at room temperature. Used herein, room temperature refers to a range of 600K or below, for example 550K or below or 400Kor below. For example, it may be 200K to 400K, or 250K to 350K.

A method of manufacturing the thermoelectric material is described below.

The thermoelectric material may be manufactured by steps including:

heating a raw material including a metal additive and a thermoelectric matrix having grains with a composition of Formula 1 below to obtain a melt;
forming a solidified intermediate via eutectic reaction using rapid solidification of the melt; and
pressure-sintering of the intermediate to obtain the thermoelectric material having a semi-coherent interface between the grains:

$$[\text{Formula 1}]$$

$$(Bi_xSb_{1-x})_a(Te_ySe_{1-y})_b$$

wherein, $1.8 \leq a \leq 2.2$, $2.8 \leq b \leq 3.2$, $0 \leq x \leq 1$, and $0 \leq y \leq 1$.

The metal additive used as a raw material may remain in part in the resulting product.

The thermoelectric material may be prepared via melt-spinning or gas atomization, one of the rapid cooling methods, followed by pressure-sintering in this order.

The melt-spinning is a method for rapid solidification by spraying a melt of a raw material on a rotating metal wheel. For example, a ribbon-shaped intermediate, where the metal additive is precipitated, can be obtained by a process, which includes heating and melting the raw material including the thermoelectric matrix and the metal additive, discharging the resultant from a nozzle to a rotating metal wheel, thereby subjecting the resultant to cooling and solidification. The intermediate is obtained in a form where the thermoelectric material and the metal additive are dispersed due to the effect of rapid cooling. Further, by subjecting the intermediate to pressure-sintering, a thermoelectric material having a semi-coherent interface on the grain boundary between the grains of the thermoelectric matrix and/or on the interface between the grains and the metal additive is achieved.

The gas atomization is a method to obtain metal powders by spraying a melted metal through an orifice by pressure. As the melted metal passes through a nozzle by gas pressure, the turbulence generated therein causes atomization of the metal. This intermediate is obtained in the form where the atomized thermoelectric material and metal additive are dispersed. Then, as the intermediate is subjected to pressure-sintering, the metal additive is changed into a melt state and rearranges the grains in the thermoelectric matrix, thereby obtaining a thermoelectric material where a semi-coherent interface is formed between the grains.

A melt-spinning method is used to form an interface that includes high density dislocations between the grains, and/or between the grains and the metal additive. For example, the melt-spinning method may be performed in the form of obtaining a rapid solidification by dropping a thermoelectric matrix melt on a copper wheel rotating at high speed via a quartz tube nozzle, and, as a result, a ribbon-shaped material with a thickness of $1\mu m$ to $100\mu m$ may be obtained. The ribbon is obtained in the form where the metal additive is dispersed in the thermoelectric material, and, due to the effect of the rapid cooling, the thermoelectric material and the metal additive may be obtained in the size of a few tens of nm to a few hundreds of nm.

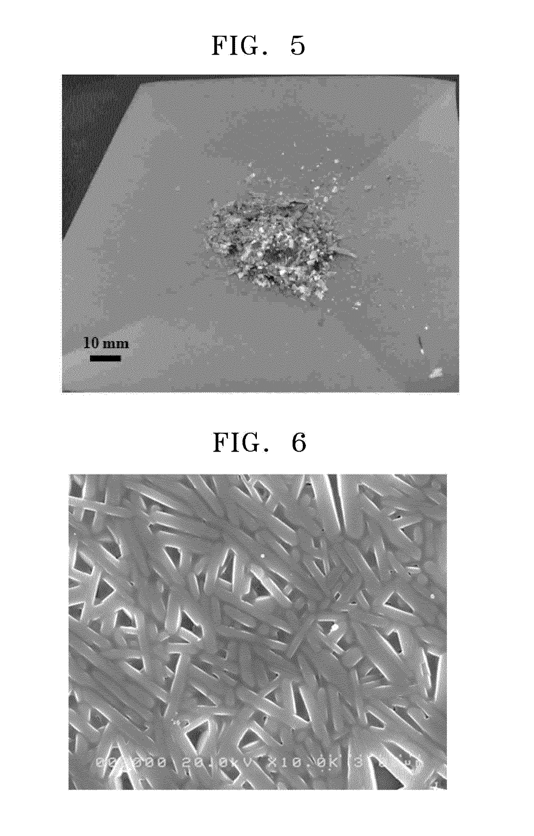

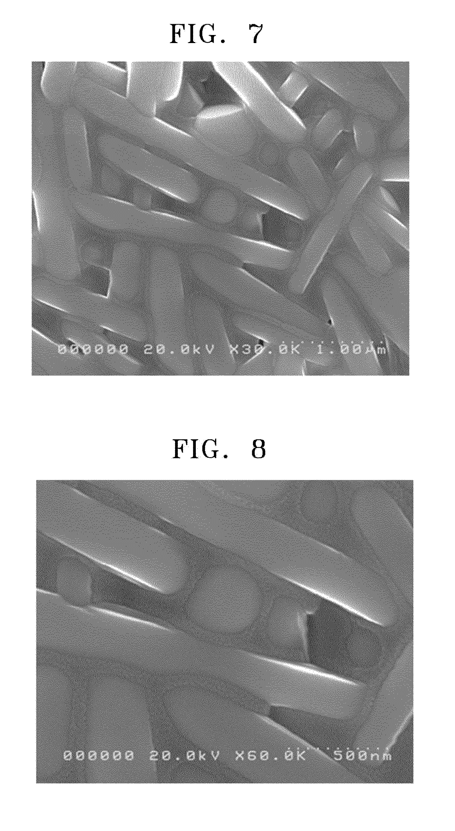

For example, when a ribbon is formed via melt-spinning as shown in FIG. 5 using $Bi_{0.5}Sb_{1.5}Te_3$ as a material for the thermoelectric matrix and Te as a metal additive, the surface shape of the ribbon may be formed as shown in FIGS. 6 and 7. When Te as a metal additive is added excessively to the $Bi_{0.5}Sb_{1.5}Te_3$ melt, there occurs a eutectic decomposition during crystallization thereby causing precipitation of Te. Here, Te precipitation is very uniformly dispersed, and it may be exhibited in the form where Te particles are intercalated into each facet of $Bi_{0.5}Sb_{1.5}Te_3$, as shown in FIGS. 8-11. As described above, this may be a suitable condition for improving the interface density of $Bi_{0.5}Sb_{1.5}Te_3$/Te with high density misfit dislocations.

The melt-spinning to be used may be any method known in the related art, and there is no limitation thereto. For example, as the cooling speed becomes faster, the interface density of $Bi_{0.5}Sb_{1.5}Te_3$/Te becomes greater.

After pulverizing the ribbon-shaped intermediate prepared via melt-spinning, for example, pressure-sintering may be performed using Spark Plasma Sintering. At the time of pressure-sintering, the sintering temperature may be higher than the melting temperature of a metal additive, for example tellurium, so that the thermoelectric matrix, for example, the $Bi_{0.5}Sb_{1.5}Te_3$/Te interface, can become a semi-coherent state. The above sintering temperature may be performed at a temperature higher than that of the melting point of the metal additive, for example, at a temperature higher than the melting temperature, i.e., at about (melting temperature + 30) °C.

The melting temperature of tellurium under atmospheric pressure is 449.57°C, and it becomes lower depending on the pressure being employed. This is due to the behavior that the crystallization of the crystal face of $Bi_{0.5}Sb_{1.5}Te_3$ may begin after tellurium changes into a liquid phase. Since the tellurium is in the liquid phase during pressure-sintering, a part of tellurium may be eluted to the outside.

The pressure to be employed during pressure-sintering is 30Mpa or greater, for example, in the range of 40MPa to 100MPa.

Further exemplary embodiments of manufacturing the thermoelectric material are described below. The methods described below are thought to be more suitable for commercial application than those described above.

The thermoelectric material may be obtained by steps which include:

mixing a raw material including a metal additive and a thermoelectric matrix having grains with a composition of Formula 1 below in a fine powder form via milling process to obtain a mixed powder; and

pressure-sintering the mixed powder to obtain the thermoelectric material having a semi-coherent interface between the grains and/or on the interface between the grains and the metal additive;

[Formula 1]

$$(Bi_xSb_{1-x})_a(Te_ySe_{1-y})_b$$

wherein, $1.8 \leq a \leq 2.2$, $2.8 \leq b \leq 3.2$, $0 \leq x \leq 1$, and $0 \leq y \leq 1$.

The thermoelectric material may be manufactured, for example, by preparing a mixed powder sized from about a few tens of nm to about a few tens of $\mu$m via high energy milling, followed by pressure-sintering, in this order. During the pressure-sintering, the metal additive melts and rearranges the grains in the thermoelectric matrix, thereby obtaining a thermoelectric material where a semi-coherent interface is formed between the grains, and/or on the interface between the grains and the metal additive.

The high energy milling to be used may be any method known in the related art, and there is no limitation thereto. For example, as the size of the mixed powder becomes smaller, the interface density of $Bi_{0.5}Sb_{1.5}Te_3$/Te becomes greater.

The pressure-sintering may be performed as is the case with the use of the above-mentioned melt-spinning method.

As described above, the thermal conductivity of the thermoelectric material can be considerably reduced by employing the process of producing the semi-coherent interface at high density by uniformly adding the metal additive to the thermoelectric matrix. The reduced thermal conductivity indicates the improvement in the thermoelectric performance.

In the case of a thermoelectric material which includes a metal additive obtained by the above process, it is possible to perform an additional high densification process. The high densification process will enable further improvement in thermal conductivity.

In another embodiment, a thermoelectric device may be obtained by molding the thermoelectric materials prepared according to the embodiments via a process such as cutting process.

The thermoelectric device may be a p-type or n-type thermoelectric device. The thermoelectric device means that the thermoelectric material is molded into a predetermined shape, for example, a hexagonal shape.

Meanwhile, the thermoelectric device may be linked to an electrode and thereby exhibit a cooling effect via applied current, and may serve as a component to indicate power generation effect according to the device or difference in temperature.

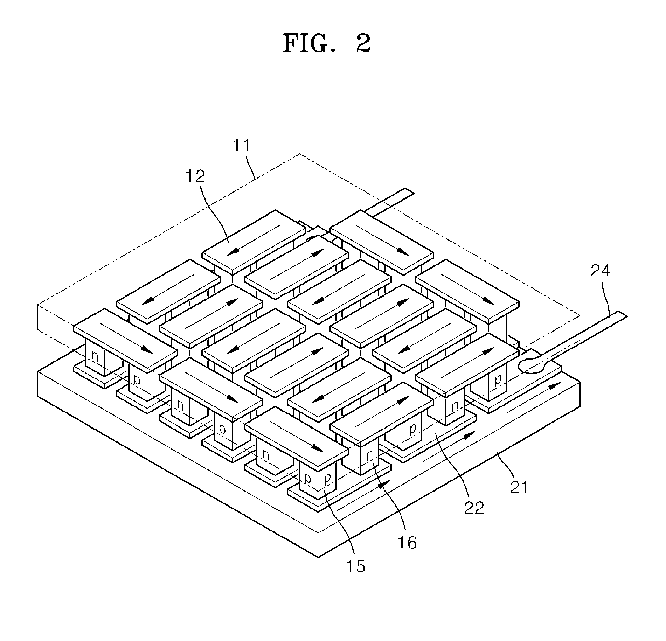

FIG. 2 shows a thermoelectric module employing a thermoelectric device according to an embodiment. As shown in FIG. 2, in the upper insulating substrate 11 and the lower insulating substrate 21, there are formed the upper electrode 12 and the lower electrode 22 in patterns, and the upper electrode 12 and the lower electrode 22 are in contact with p-type thermoelectric component 15 and n-type thermoelectric component 16. These electrodes 12 and 22 are connected to the external part of the thermoelectric device via lead electrode 24.

As the insulating substrate 11 and 21, GaAs, sapphire, silicon, pyrex, quartz substrate, etc., may be used. The material for these electrodes 12 and 22 may be selected from aluminum (Al), nickel (Ni), aurum (Au), titanium (Ti), etc., and its size may be freely selected. The patterning method to be used for these electrodes 12 and 22 may be any method known in the related art, for example, lift-off semiconductor process, deposition method, photolithography, etc.

In another embodiment, there is provided a thermoelectric module that includes the first electrode, the second electrode, and a thermoelectric device including the thermoelectric material according to Formula 1 disposed between the first electrode and the second electrode. The thermoelectric module may further include an insulating substrate where at least one of the first electrode and the second electrode is provided. As such, an insulating substrate the above-mentioned insulating substrate may be used.

In an embodiment of the above thermoelectric module, one of the first electrode and the second electrode may be electrically connected to a power supply.

In an embodiment of the thermoelectric module, the p-type thermoelectric device and the n-type thermoelectric device may be reciprocally arranged as shown in FIG. 2. Further, at least one of the p-type thermoelectric device and n-type thermoelectric device may include a thermoelectric material having the nano inclusion intercalated therein.

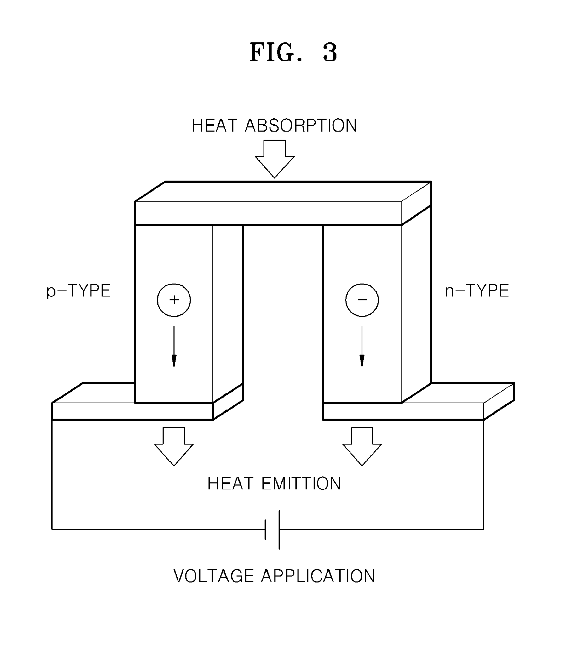

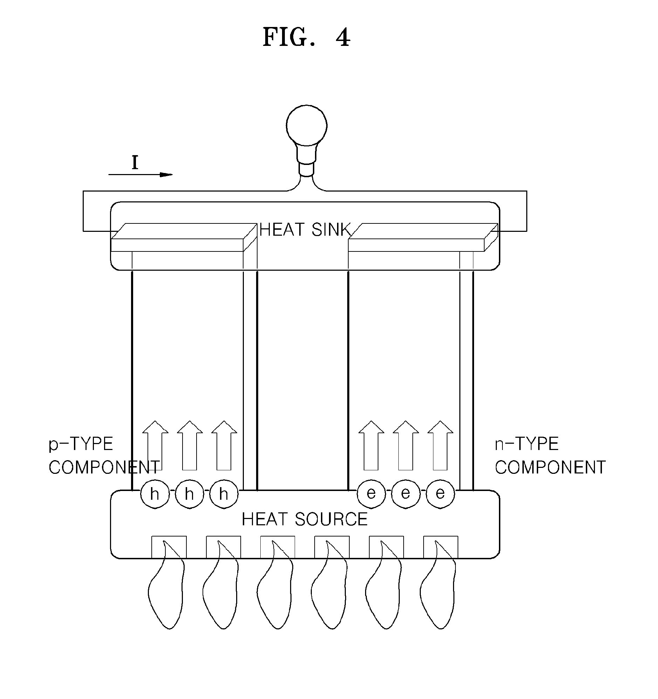

In an embodiment of the thermoelectric module, at least one of the first electrode and the second electrode may be exposed to a heat supply source as shown in FIGS. 3 and 4. In an embodiment of the thermoelectric device, at least one of the first electrode and the second electrode may be electrically connected to a power supply source as shown in FIG. 3, or be electrically connected to an exterior of the thermoelectric module, for example, an electric device, for example a battery, which consumes or stores electric power as shown in FIG. 4.

Hereinafter reference will now be made in detail to various embodiments of the present invention, examples of which are illustrated in the accompanying drawings and described below. While the invention will be described in conjunction with exemplary embodiments, it will be understood that present description is not intended to limit the invention to those embodiments. On the contrary, the invention is intended to cover not only the embodiments, but also various alternatives, modifications, equivalents and other embodiments, all of which may be included within the scope of the invention as defined by the appended claims.

## Example 1

### 1) Ribbon Preparation - Melt Spinning

Melt Spinning was used to uniformly disperse tellurium in $Bi_{0.5}Sb_{1.5}Te_3$, a thermoelectric matrix with a crystal grain structure.

When an excess amount of tellurium is added to melted $Bi_{0.5}Sb_{1.5}Te_3$ for solidification, excess tellurium is precipitated via eutectic decomposition. Because tellurium is precipitated during crystallization of $Bi_{0.5}Sb_{1.5}Te_3$ in the course of rapid solidification, a ribbon of intended type may be prepared. Further, a fine structure is formed during rapid cooling (solidification), and thus high density $Bi_{0.5}Sb_{1.5}Te_3$/Te interface can be formed.

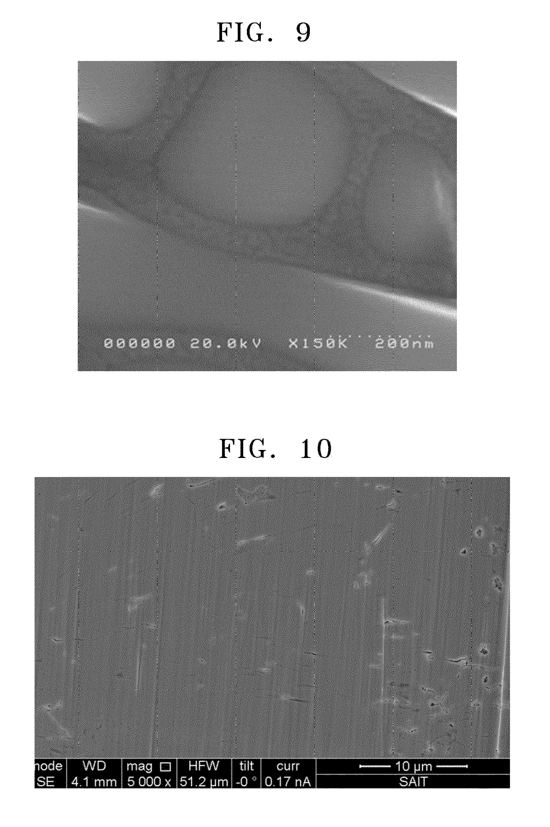

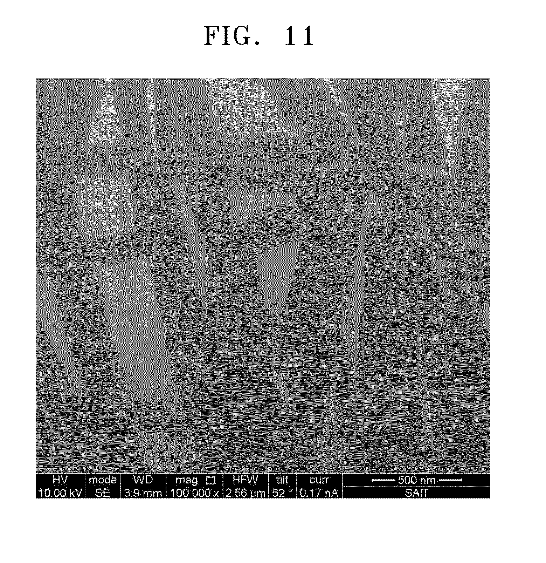

To this end, $Bi_{0.5}Sb_{1.5}Te_3$ material including an excess amount of tellurium of 20 weight% was melted and then subjected to melt-spinning under the condition of 45m/s of linear velocity of copper wheel, with a quartz tube outlet diameter of 0.3 mm, argon (Ar) pressure of 20 kPa discharge pressure, about 100-300 mTorr argon atmosphere. The melting of the material was performed via induction melting (35 A, 90V). As a result, the ribbon as shown in FIG. 5 was obtained, and detailed fine structures of the ribbon are shown in FIGS. 6-11. As can be seen in FIG. 6, it appears as a shape where the facet of the crystal of $Bi_{0.5}Sb_{1.5}Te_3$ is shown from the upper face. As shown in FIG. 7, a partial enlarged view of FIG. 6, $Bi_{0.5}Sb_{1.5}Te_3$ and Te particles were precipitated and uniformly dispersed on the facet surface of $Bi_{0.5}Sb_{1.5}Te_3$. In addition, precipitated Te particles were identified in FIGS. 8 and 9, partial enlarged views of FIG. 7. FIGS. 10 and 11 show the cross-sectional fine view of ribbons prepared in Example 1.

### 2) Pressure-Sintering - Spark Plasma Sintering

The ribbon, prepared in the above process with dispersed tellurium, was obtained in powder form by pulverization, and the obtained powder was subjected to pressure-sintering for 3 minutes at 480°C under 70MPa via spark plasma sintering, and naturally cooled in a chamber. Because 480°C is a temperature higher than the melting temperature of tellurium, a certain amount of tellurium is eluted outside of a pressure mold by pressure during the pressure process.

3) Structure Analysis

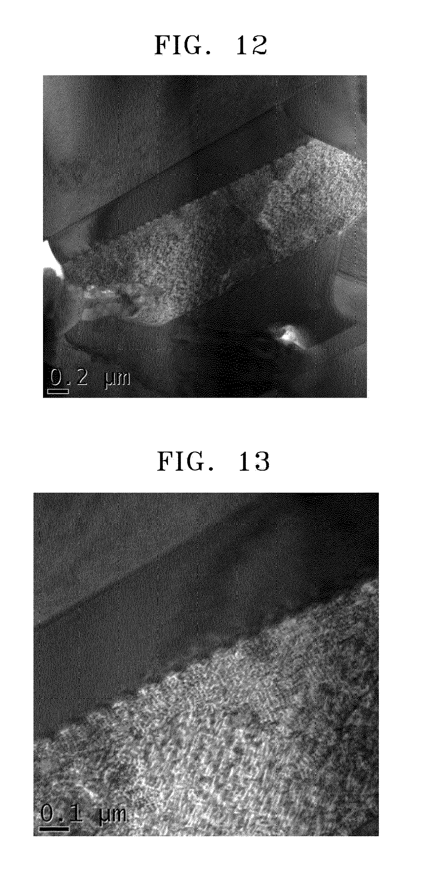

Referring to the above raw materials $Bi_{0.5}Sb_{1.5}Te_3$ and Te, Te has a structure of hexagonal system where a=4.458Å and c=5.927 Å, and $Bi_{0.5}Sb_{1.5}Te_3$ has a rhombohedral structure where a=4.292Å and c=30.45Å, a lattice matching structure where the lattice mismatch between the two is less than 3%. In the c-axis direction of $Bi_{0.5}Sb_{1.5}Te_3$, five similar lattices are stacked up, establishing a lattice matching with the five lattices along the c-axis of Te. The calculation of the interval and the distance of lattices where dislocations are formed reveals that there are dislocations of y*30.45=(y+1)*(5*5.927) toward a c-axis, where y is about 36, indicating the presence of dislocations at intervals of 36 lattices, which is about 36*30.45, i.e., 1,107Å (about 110nm). That is, a dislocation is present at intervals of 110nm toward the c-axis, which is the dislocation observed at intervals of about 100nm in FIGS. 12 and 13. FIG. 12 shows a TEM image of a semi-coherent interface (c-axis) of $Bi_{0.5}Sb_{1.5}Te_3$ and Te obtained in the above pressure-sintering, and FIG. 13 shows a partial enlarged view.

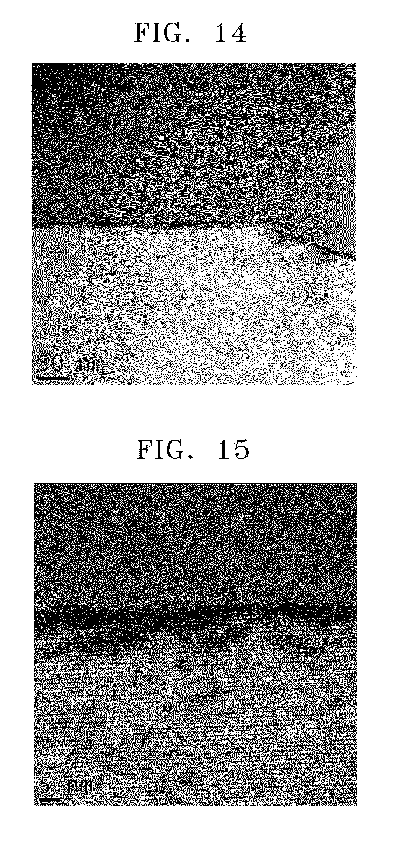

Further, toward the a-axis direction, an x lattice interval is present, calculated via x*4.458 = (x+1)*4.292, where x is about 26. That is, there is one dislocation at intervals of 26 lattices, and the distance is 26*4.458Å, which is about 115A (11.5 nm). FIG. 14 shows a TEM image of a semi-coherent interface (a-axis) of $Bi_{0.5}Sb_{1.5}Te_3$ and Te obtained in the above pressure-sintering, and FIG. 15 shows a partially enlarged view. The TEM images shown in FIGS. 14 and 15 illustrate the interface toward the direction of a-axis, the interval being about 10nm, and there is observed to be an overlap in the region of strain field. The interfaces shown in FIGS. 12-15 are present as surfaces and not as lines, and, toward the interface in-plane direction, there is a structure formed with a two-dimensional and very dense dislocation. This shows one example where a semi-coherent interface of $Bi_{0.5}Sb_{1.5}Te_3$ and Te may occur. Further, in other facet surfaces which are not in parallel with a-axis or c-axis, various forms of dense dislocations may be formed, and the strain field around the dislocations may affect the decrease in thermal conductivity. For example, there may be present a semi-coherent interface of $Bi_{0.5}Sb_{1.5}Te_3$ and Te, where a-axis is arranged at 30° intervals.

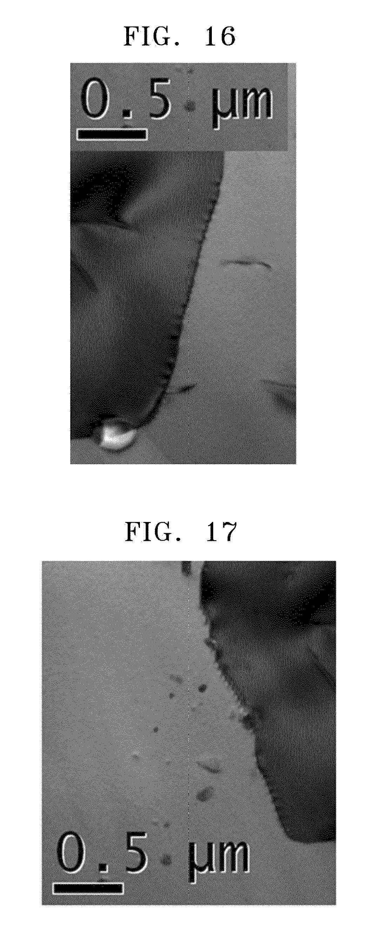

FIGS. 12-15 show dislocations of simple facet surfaces. Meanwhile, FIGS. 16-22 are TEM images of the ribbon preparation and final products obtained via pressure-sintering showing the multiple complex dislocations and threading dislocations/tangled dislocations developed from the dislocations.

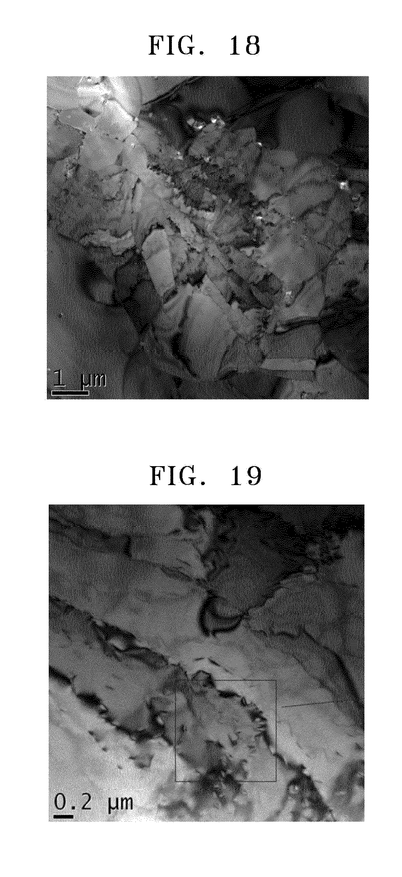

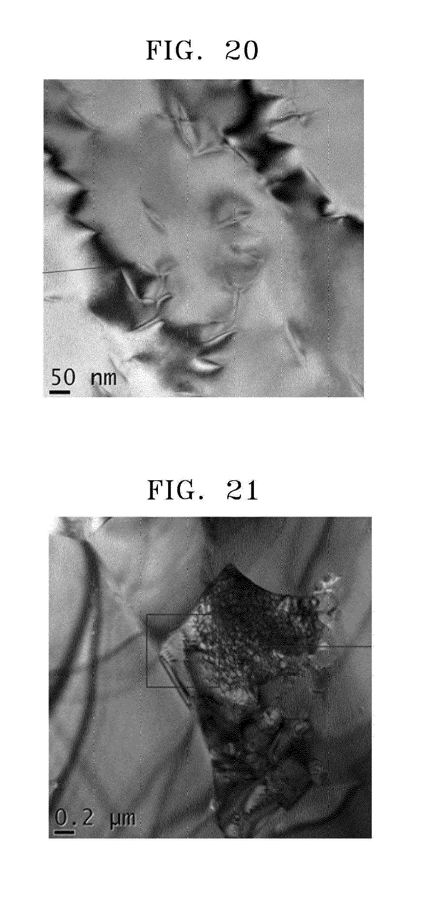

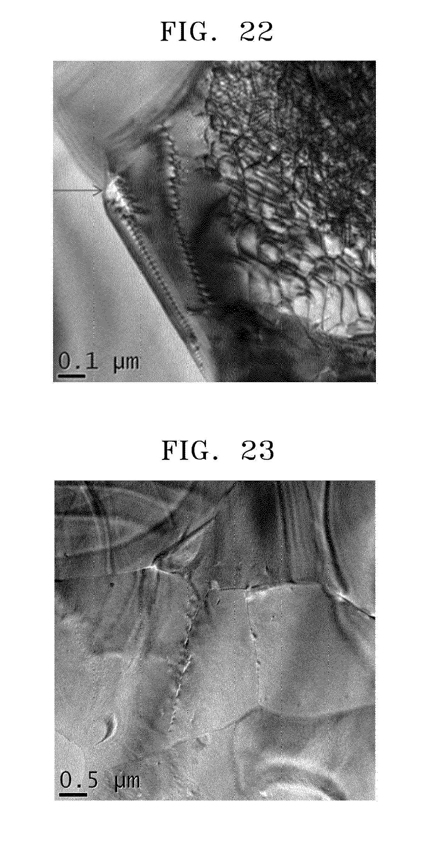

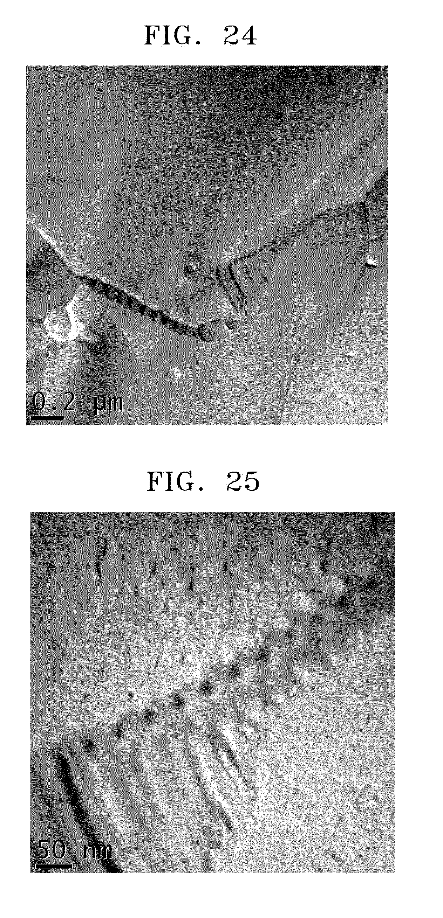

FIGS. 16 and 17 clearly show the periodic dislocations being observed in the $Bi_{0.5}Sb_{1.5}Te_3$/Te interface, and FIG. 18 shows that many dislocations are intricately intermingled over a wide range. FIG. 19 and FIG. 20, a partial enlarged view of FIG. 19, show the threading dislocations appearing as lines due to the continuous occurrence of dislocations that result when the dislocation interval is narrow or the range of strain field is overlapped. FIG. 21 and FIG. 22, a partial enlarged view of FIG. 21, also show tangles dislocations intermingled due to the narrow interval between the dislocations. FIG. 23-27 respectively show dislocations additionally formed along the grain boundary.

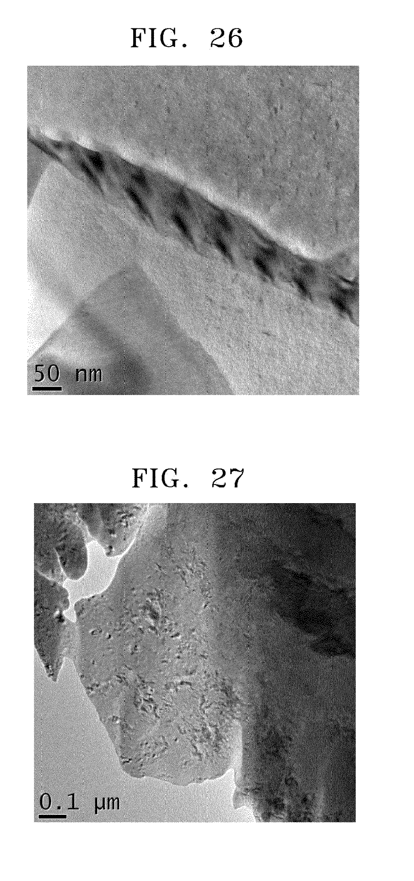

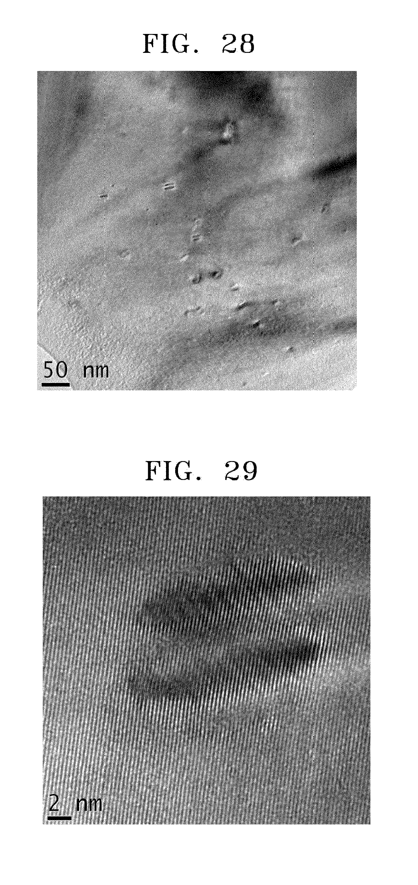

FIG. 27-29 show tellurium nanoparticles formed within the grains, and dislocations are observed around the nanoparticles. The tellurium nanoparticles formed within grains appear so that the tellurium nanoparticles, which have been under supersaturation during a rapid cooling process, are deposited on a nano scale during the sintering process.

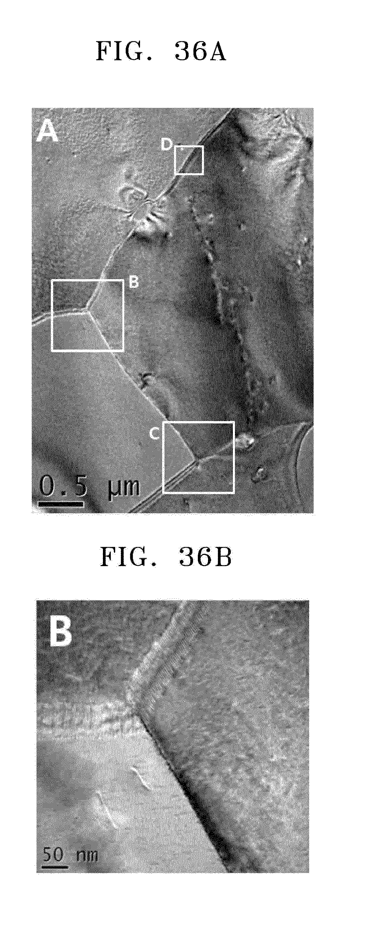

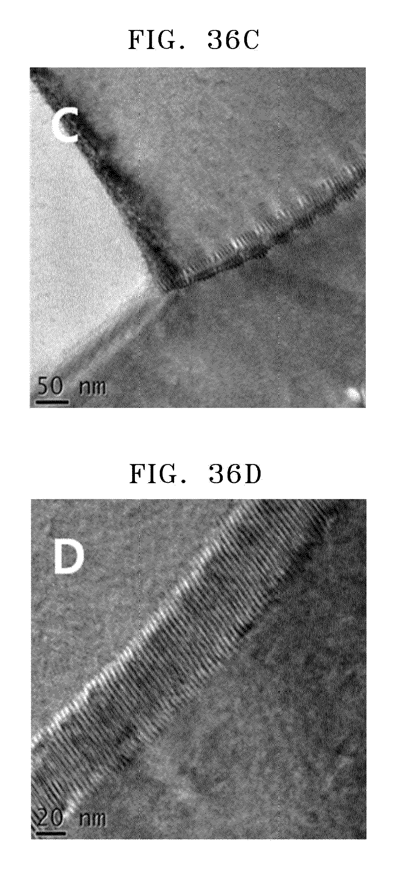

FIG. 36a, 36b, 36c and 36d show TEM images of thermoelectric materials prepared in Example 1, wherein the images are respectively at different magnifications, and a high defect density is observed among grains at high magnification. It appears that dislocations might have occurred at both interfaces, thereby forming a dislocation loop.

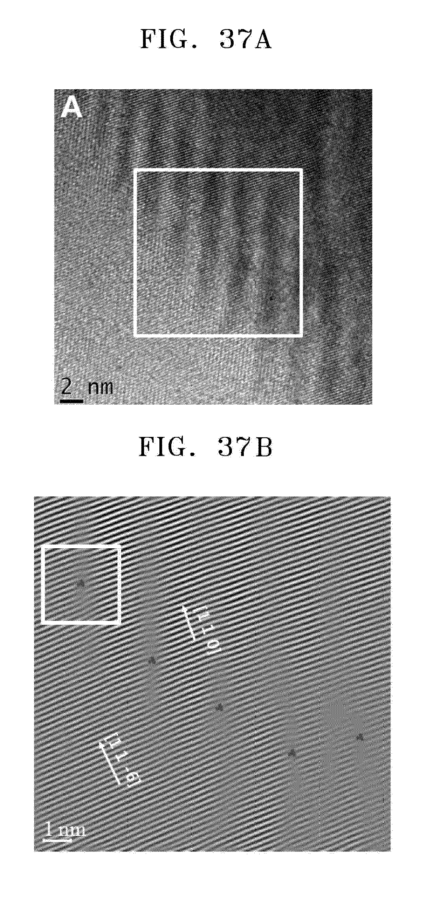

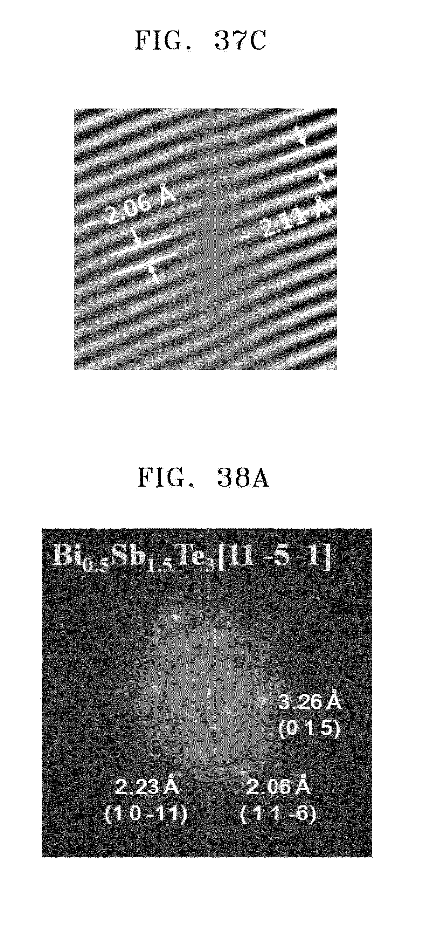

FIG. 37a shows a TEM image of thermoelectric materials prepared in Example 1. FIG. 37b shows a filtered image of spots on $Bi_{0.5}Sb_{1.5}Te_3$ (1 1 -6) face and (1 1 0) face in the lattice diffraction pattern of TEM image, with dislocation clearly illustrating a regular structure of dislocation.

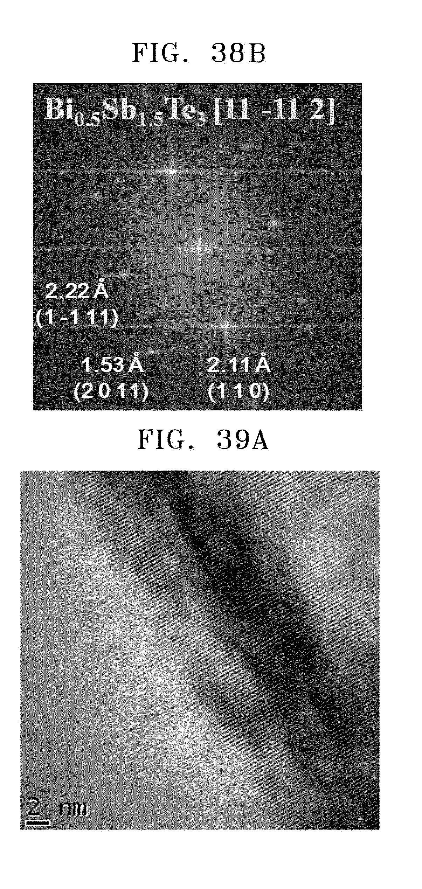

FIGS. 38a and 38b show the lattice diffraction pattern of FIG. 37a prepared in Example 1. FIG. 38a is a zoomed in portion of a lattice diffraction pattern of the left lower portion of FIG. 37a, where $Bi_{0.5}Sb_{1.5}Te_3$ is present as zone axis of [11 -5 1], and FIG. 38b is zoomed in portion of a lattice diffraction pattern of the right upper portion of FIG. 37a, where $Bi_{0.5}Sb_{1.5}Te_3$ is present as zone axis of [11 -11 2].

Through FIGS. 37a-37c and FIGS. 38a-38b, it is apparent that an interface is present, the interface having a lattice relationship) of $Bi_{0.5}Sb_{1.5}Te_3$ [11 -5 1] // [11 -11 2] and $Bi_{0.5}Sb_{1.5}Te_3$ [1 1 -6] // [1 1 0].

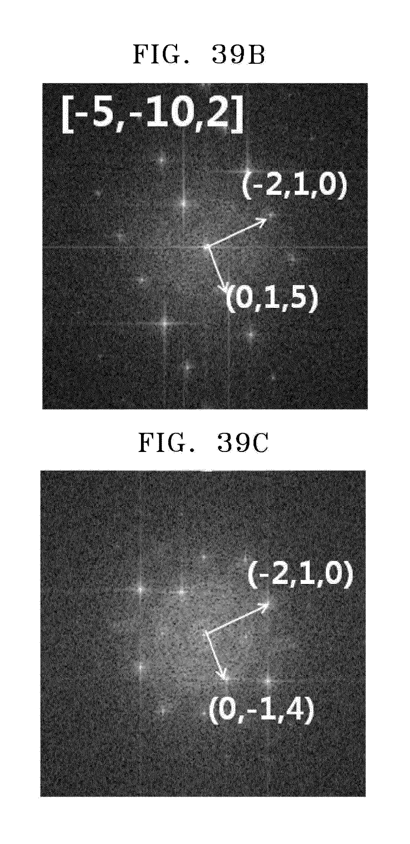

FIG. 39a shows a TEM image of thermoelectric materials prepared in Example 1, wherein a strain field is observed at the interface; and FIGS. 39b and 39c show lattice diffraction patterns of FIG. 39a prepared in Example 1. The (-2 1 0) face of two grains are in a coherent matching, and (0,1,5) face and (0,-1,4) face are in a semicoherent matching.

### Example 2

1) Preparation of Mixed Powder (High Energy Milling)

High energy milling was used to uniformly disperse tellurium in $Bi_{0.5}Sb_{1.5}Te_3$, a thermoelectric matrix.

High energy milling was performed on $Bi_{0.5}Sb_{1.5}Te_3$ mixed with an excess amount of tellurium. The high energy milling was performed by mixing stainless steel ball and raw materials, adding the mixture to a stainless steel container, filling the container with an inert gas, and then performing the milling for more than a few hours.

The high energy milling produces a mixed powder of $Bi_{0.5}Sb_{1.5}Te_3$ and tellurium. Fine powder of $Bi_{0.5}Sb_{1.5}Te_3$ and tellurium is mixed during the high energy milling process and thereby forms a high density $Bi_{0.5}Sb_{1.5}Te_3$/Te interface during the sintering process.

Then, the above mixed powder was subjected to a pressure-sintering using the spark plasma sintering of Example 1.

The structure of a pellet thus obtained from the pressure-sintering is similar to that of Example 1, and the structure and shape of the high density $Bi_{0.5}Sb_{1.5}Te_3$/Te interface was similar, thus decreasing lattice thermal conductivity, but the density of $Bi_{0.5}Sb_{1.5}Te_3$/Te interface becomes smaller than that of Example 1.

### Comparative Example 1

Stoichiometric $Bi_{0.5}Sb_{1.5}Te_3$ not containing an excess amount of tellurium was subjected to pressure-sintering under the same conditions as in Example 1, thereby obtaining a thermoelectric material.

### Comparative Example 2

Stoichiometric $Bi_{0.5}Sb_{1.5}Te_3$ not containing an excess amount of tellurium was subjected to melt-spinning under the same conditions as in Example 1 to prepare a ribbon, thereby obtaining a thermoelectric material.

### Experimental Example 1: Measurement of Thermoelectric performance

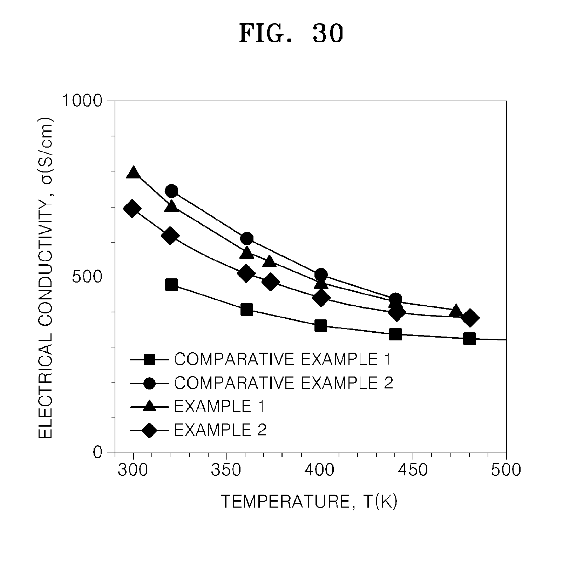

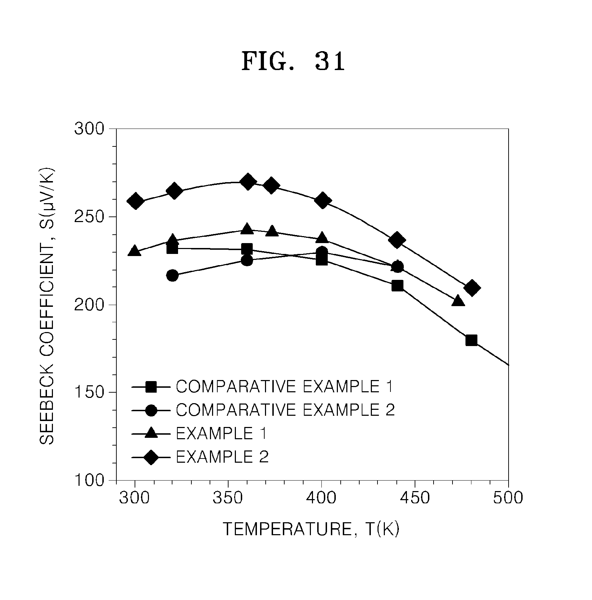

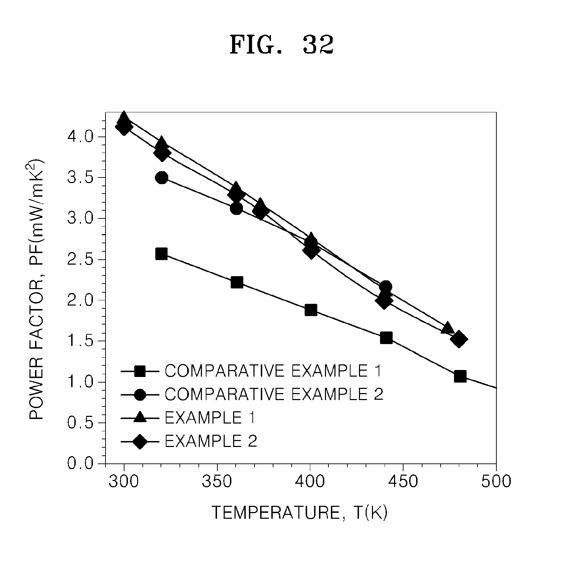

Thermal conductivity and Seebeck coefficient of thermoelectric materials prepared by the above process in Example 1, Comparative Example 1 and Comparative Example 2 were simultaneously measured using ULVAC ZEM-3, and the results are shown in FIGS. 30 and 31. Power factors calculated therefrom are shown in FIG. 32.

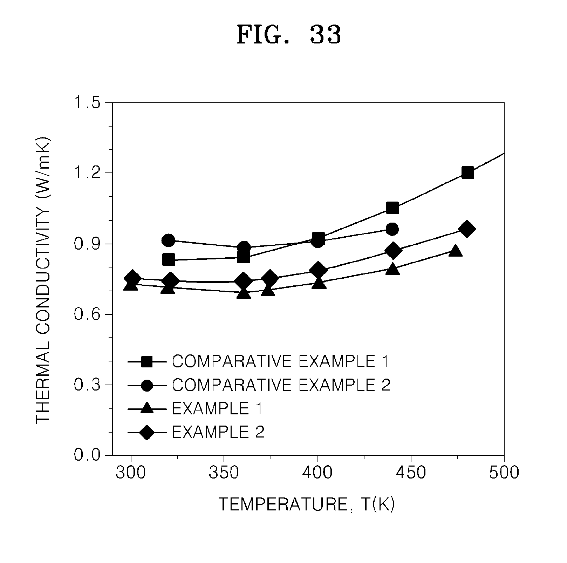

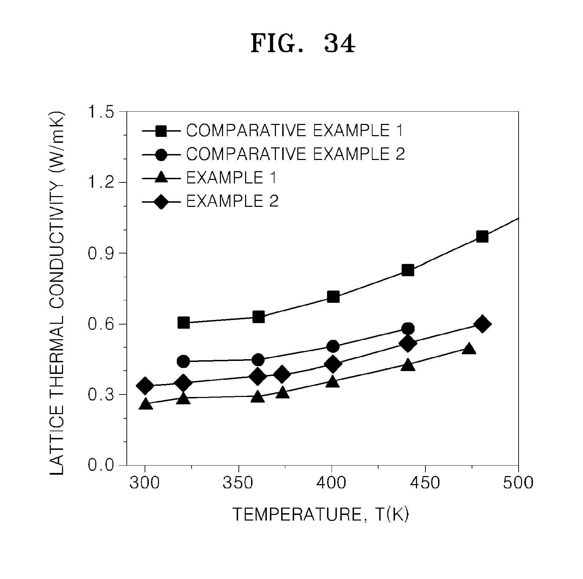

Further, the thermal conductivity was calculated from the thermal diffusivity measured via ULVAC TC-9000H (Laser Flash method), and the result is shown in FIG. 33. The lattice thermal conductivity was calculated assuming that Lorenz constant is $L=2 \times 10^{-8}$ WOhmK$^{-2}$, and the result is shown in FIG. 34.

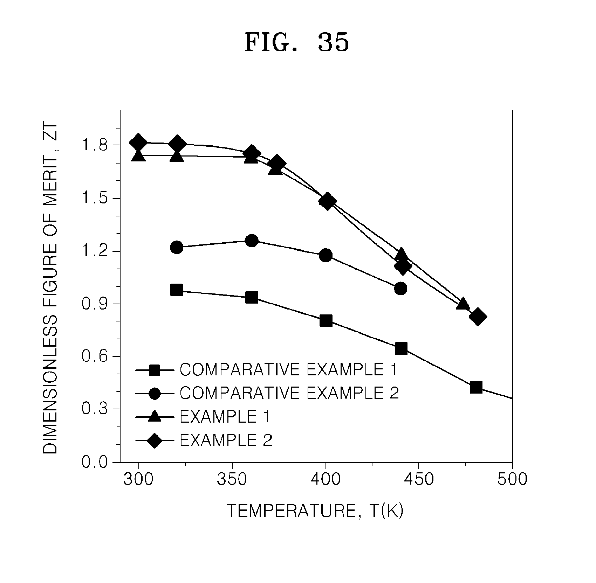

The thermoelectric figure of merit (ZT) calculated from the above result is shown in FIG. 35.

The thermal conductivity of Example 1 and Example 2 shown in FIG. 30 is similar to that of Comparative Example 2, in which only melt-spinning was performed. As compared to $Bi_{0.5}Sb_{1.5}Te_3$ of Comparative Example 1 with respect to a comparative material, the increase in thermal conductivity appears to be due to the melt-spinning and high energy milling. The Seebeck coefficient of Example 1 shown in FIG. 31 shows an increase in comparison to that of Comparative Example 2, and this may be due to the Carrier Filtering effect at the $Bi_{0.5}Sb_{1.5}Te_3$/Te interface. However, the effective increase is insignificant, and the power factor as shown in FIG. 32 is similar to that of Comparative Example 2. Therefore, the major reason for the increase of power factor in comparison to Comparative Example 1 is certainly due to the melt-spinning.

FIG. 33 shows the thermal conductivity of Example 1, Example 2, Comparative Example 1 and Comparative Example 2. FIG. 33 shows that the thermal conductivity of both Example 1 and Example 2 significantly decreased.

FIG. 34 shows calculation results of the lattice thermal conductivity of Example 1, Comparative Example 1 and Comparative Example 2, assuming that Lorenz constant is $L=2 \times 10^{-8}$ WOhmK$^{-2}$. Example 1 showed a very low value of 0.2-0.3 W/mK in comparison to 0.6 W/mK of Comparative Example 1 and 0.4 W/mK of Comparative Example 2.

Melt-spinning alone may lower the lattice thermal conductivity, however, it was confirmed in Example 1 that the presence of dislocations considerably reduced the lattice thermal conductivity. The observed dislocations and complex dislocations generated therefrom due to their correlation formed a strain field, thereby lowering lattice thermal conductivity. Accordingly, it was confirmed that the thermal conductivity was drastically lowered by producing high density semi-coherent interface at high density by uniformly adding tellurium.

The reduction of lattice thermal conductivity of Example 2 was less than that of Example 1, in which the thermoelectric material was prepared by melt-spinning, but the effect of reduction in the thermal conductivity. This was performed via high energy milling, a process that may easily be implemented on a large scale.

The thermoelectric figures of merit ZT of Example 1, Example 2 Comparative Example 1 and Comparative Example 2 calculated based on the above values are shown in FIG. 35. The ZT at room temperature was 1.7 or higher and the maximum ZT recorded was 1.74 @ 87K. This is a performance related to temperatures related to commercial use, and is a very excellent value. Further, melt-spinning is a process capable of being implemented for large scale production, thus expanding its area of application and commercialization. In particular, by means of high energy milling, the ZT was 1.6 or greater, and the maximum ZT was 1.65 @ 87K. High energy milling is even more convenient than the melt-spinning process, and, with its capability of mass production, it will also contribute to reducing the cost of high performance thermoelectric materials.

The present invention provides a thermoelectric material with a much lowered thermal conductivity, wherein at least one of the crystal faces on the grain boundary included in the $(Bi,Sb)_2(Te,Se)_3$-based thermoelectric matrix forms a semi-coherent interface. The grain boundary in the thermoelectric matrix, for example, forms a semi-coherent interface, and this may include a high density dislocation. Further, a semi-coherent interface may be formed between grains of the thermoelectric matrix and the metal additive having a lattice matching structure, and this may include a high density dislocation.

The lattice thermal conductivity of the above thermoelectric material is very low, at about 0.4 W/mK or less, and, as a result, a considerably high thermoelectric performance is expressed. Further, ZT, the thermoelectric figure of merit indicating the thermoelectric performance, is very high at room temperature. In addition, because the thermoelectric material can be manufactured by a process that may be implemented easily on a large scale, it is possible to extend the area of its application and commercialization.

In summary, it has been demonstrated that grain boundaries with high-density periodic misfit dislocation arrays are formed between adjacent grains during sintering of Te-catalyst assisted grain rearrangement. The dislocation arrays for instance spontaneously formed during transient sintering wherein liquid self-flux Te stimulates grain rearrangements, accommodating mismatches of near coincidence site lattices of adjacent grains.

The presence of liquid Te self-flux during the sintering process enables the grain rearrangement that can form crystallographic relationship to lower grain boundary energy, which generate periodic misfit dislocation arrays. The generation of dislocations can be explained by coincident site lattice (CSL) or structural-unit models. At certain orientation relationship is established between adjacent grains as to have lower grain boundary energy during the grain rearrangement by the transient liquid-Te self-flux sintering. For some discrete misorientations between grain crystals, a coincident site lattice, which is common to the two adjacent grains, may be defined. The deviation from the exact coincidence site (Near-CSL) lattice misorientation creates high-density dislocations at the boundary. It is notable that these misfit dislocations are inherently stable. It can be simply thought of periodic misfit dislocations formed due to d-spacing mismatch of adjacent grains at a certain orientation relationship. This can lower grain boundary.

While an exemplary embodiment of the present invention has been described in detail, the protection scope of the present invention is not limited to the foregoing embodiment, and it will be appreciated by those skilled in the art that various modifications and improvements using the basic concept of the present invention defined in the appended claims are also included in the protection scope of the present invention.

**Claims**

1. A thermoelectric material comprising:

   a thermoelectric matrix comprising grains with a composition of Formula 1:

$$\text{Formula 1}$$
$$(Bi_xSb_{1-x})_a(Te_ySe_{1-y})_b$$

   wherein, $1.8 \leq a \leq 2.2$, $2.8 \leq b \leq 3.2$, $0 \leq x \leq 1$, and $0 \leq y \leq 1$, **characterised in that** at least one grain boundary in said thermoelectric matrix comprises a plurality of dislocations.

2. The thermoelectric material of claim 1, wherein said dislocations along a grain boundary are present between adjacent grains of the composition of Formula 1.

3. The thermoelectric material of claim 1 or 2, wherein the thermoelectric matrix further comprises an additive.

4. The thermoelectric material of claim 3, wherein a semi-coherent interface is present between a grain of the composition of Formula 1 and the additive.

5. The thermoelectric material of claim 4, wherein the semi-coherent interface further comprises an array comprising a plurality of dislocations.

6. The thermoelectric material of any one of claims 3-5, wherein the additive is a metal additive, and wherein a difference between a lattice constant of the metal additive and a lattice constant of the composition of Formula 1 of the grain is 15 percent or less.

7. The thermoelectric material of any one of claims 3-6, wherein the additive comprises tellurium.

8. The thermoelectric material of any one of claims 3-7, wherein the additive is a chalcogenide compound.

9. The thermoelectric material of any of claims 1-8, wherein the dislocations form an array spaced at an interval of 1 nanometer to 100 nanometers.

10. The thermoelectric material of claim 1, having a lattice thermal conductivity of 0.4 Watts per meter-Kelvin or less and/or a thermoelectric figure of merit of 1.3 or greater at room temperature.

11. A method for manufacturing a thermoelectric material according to any of claims 1-10, the method comprising:

heating a precursor material comprising a flux or additive and a composition of Formula 1 to obtain a melt

## Formula 1

$$(Bi_xSb_{1-x})_a(Te_ySe_{1-y})_b \, ,$$

wherein $1.8 \leq a \leq 2.2$, $2.8 \leq b \leq 3.2$, $0 \leq x \leq 1$, and $0 \leq y \leq 1$;
solidifying the melt to form a solidified intermediate;
pressure-sintering the solidified intermediate to obtain the thermoelectric material,
wherein the thermoelectric material has a plurality of dislocations along a grain boundary of the composition of Formula 1.

12. The method of claim 11, wherein the flux or additive is Tellurium.

13. The method of claim 11 or 12, wherein an amount of the flux or additive in the thermoelectric matrix is in excess of a stoichiometry of tellurium in Formula 1.

14. The method of any of claim 11-13, wherein the additive is precipitated in the thermoelectric matrix via a eutectic reaction during the process of forming the intermediate.

15. The method of any of claims 11-13, further comprising removing the flux or additive during pressure-sintering of the solidified intermediate.

16. The method of claim 15, wherein the removing of the flux or additive comprises sintering process at the temperature higher than melting point of flux.

17. The method of any of claims 11-16, wherein a plurality of dislocations along a grain boundary between adjacent grains is formed during rearranging the grains in the thermoelectric matrix by melting the flux by the pressure-sintering of the intermediate.

**Patentansprüche**

1. Thermoelektrisches Material, umfassend:

eine thermoelektrische Matrix, umfassend Körner mit einer Zusammensetzung nach Formel 1:

Formel 1

$$(Bi_xSB_{1-x})_a(Te_ySe_{1-y})_b$$

wobei 1,8≤a≤2,2; 2,8≤b≤3,2; 0≤x≤1 und 0≤y≤1, **dadurch gekennzeichnet, dass** mindestens eine Korngrenze in der thermoelektrischen Matrix eine Vielzahl von Versetzungen umfasst.

2. Thermoelektrisches Material nach Anspruch 1, wobei die Versetzungen entlang einer Korngrenze zwischen angrenzenden Körnern der Zusammensetzung nach Formel 1 vorliegen.

3. Thermoelektrisches Material nach Anspruch 1 oder 2, wobei die thermoelektrische Matrix ferner einen Zusatzstoff umfasst.

4. Thermoelektrisches Material nach Anspruch 3, wobei eine teilkohärente Grenzfläche zwischen einem Korn der Zusammensetzung nach Formel 1 und dem Zusatzstoff vorliegt.

5. Thermoelektrisches Material nach Anspruch 4, wobei die teilkohärente Grenzfläche ferner ein Array umfasst, umfassend eine Vielzahl von Versetzungen.

6. Thermoelektrisches Material nach einem der Ansprüche 3-5, wobei der Zusatzstoff ein Metallzusatzstoff ist und wobei eine Differenz zwischen einer Gitterkonstante des Metallzusatzstoffes und einer Gitterkonstante der Zusammensetzung nach Formel 1 des Korns 15 Prozent oder weniger entspricht.

7. Thermoelektrisches Material nach einem der Ansprüche 3-6, wobei der Zusatzstoff Tellur umfasst.

8. Thermoelektrisches Material nach einem der Ansprüche 3-7, wobei der Zusatzstoff eine Chalkogenidverbindung ist.

9. Thermoelektrisches Material nach einem der Ansprüche 1-8, wobei die Versetzungen ein Array formen, das in einem Abstand von 1 Nanometer bis 100 Nanometer beabstandet ist.

10. Thermoelektrisches Material nach Anspruch 1 mit einer Gitterwärmeleitfähigkeit von 0,4 Watt pro Meter Kelvin oder weniger und/oder einem thermoelektrischen Gütefaktor von 1,3 oder mehr bei Raumtemperatur.

11. Verfahren für die Herstellung eines thermoelektrischen Materials nach einem der Ansprüche 1-10, wobei das Verfahren Folgendes umfasst:

Erwärmen eines Vorläufermaterials, umfassend ein Flussmittel oder einen Zusatzstoff und eine Zusammensetzung nach Formel 1, um eine Schmelze zu erhalten

Formel 1

$$(Bi_xSb_{1-x})_a(Te_ySe_{1-y})_b,$$

wobei 1,8≤a≤2,2; 2,8≤b≤3,2; 0≤x≤1 und 0≤y≤1;
Erstarren der Schmelze, um ein erstarrtes Zwischenprodukt zu formen;
Drucksintern des erstarrten Zwischenprodukts, um das thermoelektrische Material zu erhalten,
wobei das thermoelektrische Material eine Vielzahl von Versetzungen entlang einer Korngrenze der Zusammensetzung nach Formel 1 aufweist.

12. Verfahren nach Anspruch 11, wobei das Flussmittel oder der Zusatzstoff Tellur ist.

13. Verfahren nach Anspruch 11 oder 12, wobei eine Menge des Flussmittels oder Zusatzstoffes in der thermoelektrischen Matrix eine Stöchiometrie von Tellur in Formel 1 übersteigt.

**14.** Verfahren nach einem der Ansprüche 11-13, wobei der Zusatzstoff in der thermoelektrischen Matrix über eine eutektische Reaktion während des Vorgangs der Formung des Zwischenprodukts ausgefällt wird.

**15.** Verfahren nach einem der Ansprüche 11-13, ferner umfassend das Entfernen des Flussmittels oder Zusatzstoffes aus dem erstarrten Zwischenprodukt während des Drucksinterns.

**16.** Verfahren nach Anspruch 15, wobei das Entfernen des Flussmittels oder Zusatzstoffes einen Sintervorgang bei der Temperatur umfasst, die höher als der Schmelzpunkt des Flussmittels ist.

**17.** Verfahren nach einem der Ansprüche 11-16, wobei eine Vielzahl von Versetzungen entlang einer Korngrenze zwischen angrenzenden Körnern geformt wird, während die Körner in der thermoelektrischen Matrix durch das Schmelzen des Flussmittels durch das Drucksintern des Zwischenprodukts neu geordnet werden.

**Revendications**

**1.** Matériau thermoélectrique comprenant :

une matrice thermoélectrique comportant des grains ayant une composition de formule 1 :

$$\text{Formule 1}$$

$$(Bi_xSb_{1-x})_a(Te_ySe_{y-1})_b$$

dans laquelle $1,8 \leq a \leq 2,2$, $2,8 \leq b \leq 3,2$, $0 \leq x \leq 1$ et $0 \leq y \leq 1$,
**caractérisé en ce qu'**au moins un joint de grains dans ladite matrice thermoélectrique comporte une pluralité de dislocations.

**2.** Matériau thermoélectrique selon la revendication 1, lesdites dislocations le long d'un joint de grains étant présentes entre des grains adjacents de la composition de formule 1.

**3.** Matériau thermoélectrique selon la revendication 1 ou 2, ladite matrice thermoélectrique comprend en outre un additif

**4.** Matériau thermoélectrique selon la revendication 3, une interface semi-cohérente étant présente entre un grain de la composition de formule 1 et l'additif.

**5.** Matériau thermoélectrique selon la revendication 4, ladite interface semi-cohérente comprenant en outre un ensemble comportant une pluralité de dislocations.

**6.** Matériau thermoélectrique selon l'une quelconque des revendications 3 à 5, ledit additif étant un additif métallique, et la différence entre la constante de réseau de l'additif métallique et la constante de réseau de la composition de formule 1 du grain étant inférieure ou égale à 15 pour cent.

**7.** Matériau thermoélectrique selon l'une quelconque des revendications 3 à 6, ledit additif comprenant du tellure.

**8.** Matériau thermoélectrique selon l'une quelconque des revendications 3 à 7, ledit additif étant un composé chalcogénure.

**9.** Matériau thermoélectrique selon l'une quelconque des revendications 1 à 8, lesdites dislocations formant un ensemble étant espacées d'un intervalle de 1 nanomètre à 100 nanomètres.

**10.** Matériau thermoélectrique selon la revendication 1 ayant une conductivité thermique de réseau inférieure ou égale à 0,4 Watts par mètre-Kelvin et/ou un facteur de mérite thermoélectrique supérieur ou égal à 1,3 à température ambiante.

**11.** Procédé de fabrication d'un matériau thermoélectrique selon l'une quelconque des revendications 1 à 10, ledit procédé comprenant :

le chauffage d'un matériau précurseur comprenant un fondant ou additif et une composition de formule 1 pour obtenir une matière fondue

## Formule 1

$$(Bi_xSb_{1-x})_a(Te_ySe_{y-1})_b$$

dans laquelle $1,8 \leq a \leq 2,2$, $2,8 \leq b \leq 3,2$, $0 \leq x \leq 1$ et $0 \leq y \leq 1$ ;
la solidification de la matière fondue pour former un produit intermédiaire solidifié ;
le frittage sous pression du produit intermédiaire solidifié pour obtenir le matériau thermoélectrique ;
ledit matériau thermoélectrique comportant une pluralité de dislocations le long d'un joint de grains de la composition de formule 1.

12. Procédé selon la revendication 11, ledit fondant ou additif étant du tellure.

13. Procédé selon la revendication 11 ou 12, la quantité du fondant ou de l'additif dans la matrice thermoélectrique étant supérieure à la stoechiométrie du tellure dans la formule 1.

14. Procédé selon l'une quelconque des revendications 11 à 13, ledit additif étant précipité dans la matrice thermoélectrique par l'intermédiaire d'une réaction eutectique au cours du processus de formation du produit intermédiaire.

15. Procédé selon l'une quelconque des revendications 11 à 13 comprenant en outre la suppression du fondant ou de l'additif au cours du frittage sous pression du produit intermédiaire solidifié.

16. Procédé selon la revendication 15, ladite suppression du fondant ou de l'additif comprenant le processus de frittage à une température supérieure au point de fusion du fondant.

17. Procédé selon l'une quelconque des revendications 11 à 16, ladite pluralité de dislocations le long d'un joint de grains entre des grains adjacents étant formée au cours du réarrangement des grains dans la matrice thermoélectrique par fusion du fondant par le frittage sous pression du produit intermédiaire.

FIG. 1

DISLOCATION

FIG. 2

# FIG. 3

HEAT ABSORPTION

p-TYPE    (+)    (−)    n-TYPE

HEAT EMITTION

VOLTAGE APPLICATION

## FIG. 4

I

HEAT SINK

p-TYPE
COMPONENT

n-TYPE
COMPONENT

h    h    h

e    e    e

HEAT SOURCE

FIG. 5

FIG. 6

FIG. 7

FIG. 8

FIG. 9

000000 20.0kV X150K 200nm

FIG. 10

| node | WD | mag □ | HFW | tilt | curr | 10 μm |
| --- | --- | --- | --- | --- | --- | --- |
| SE | 4.1 mm | 5 000 x | 51.2 μm | -0 ° | 0.17 nA | SAIT |

FIG. 11

| HV | mode | WD | mag □ | HFW | tilt | curr | ——— 500 nm ——— |
|---|---|---|---|---|---|---|---|
| 10.00 kV | SE | 3.9 mm | 100 000 x | 2.56 µm | 52 ° | 0.17 nA | SAIT |

FIG. 12

FIG. 13

FIG. 14

FIG. 15

## FIG. 16

## FIG. 17

## FIG. 18

## FIG. 19

FIG. 20

50 nm

FIG. 21

0.2 μm

## FIG. 22

0.1 μm

## FIG. 23

0.5 μm

## FIG. 24

0.2 µm

## FIG. 25

50 nm

FIG. 26

50 nm

FIG. 27

0.1 μm

FIG. 28

FIG. 29

FIG. 30

FIG. 31

FIG. 32

FIG. 33

FIG. 34

FIG. 35

FIG. 36A

FIG. 36B

FIG. 36C

FIG. 36D

## FIG. 37A

## FIG. 37B

FIG. 37C

FIG. 38A

FIG. 38B

FIG. 39A

FIG. 39B

FIG. 39C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- Nanostructure and thermoelectric properties of p-type Bi0.5Sb1.5Te3 compound prepared by melt spinning technique. **XIE W J et al.** THERMOELECTRICS, 2007. ICT 2007. 26TH INTERNATIONAL CONFERENCE. IEEE, 03 June 2007, 23-26